# EUROPÄISCHE PATENTSCHRIFT

(11) **EP 1 721 082 B1**
(45) Veröffentlichungstag und Bekanntmachung des Hinweises auf die Patenterteilung: **11.06.2008**
(21) Anmeldenummer: 05715059.1
(22) Anmeldetag: 02.03.2005
(51) Int. Cl.: F15D 1/06, B64C 23/00

(54) **VERKLEIDUNG MIT INTEGRIERTEM POLYMERAKTOR ZUR VERFORMUNG DERSELBEN**
CLADDING COMPRISING AN INTEGRATED POLYMER ACTUATOR FOR THE DEFORMATION OF SAID CLADDING
REVETEMENT A ACTIONNEUR POLYMERE INTEGRE POUR LA DEFORMATION DUDIT REVETEMENT

(30) Priorität: 04.03.2004 DE 102004011030
(43) Veröffentlichungstag der Anmeldung: 15.11.2006
(73) Patentinhaber: SIEMENS AKTIENGESELLSCHAFT, 80333 München (DE)
(72) Erfinder: ARNDT, Frank, 10627 Berlin (DE); KRÜGER, Ursus, 14089 Berlin (DE); LÜTHEN, Volkmar, 12157 Berlin (DE); STECKENBORN, Arno, 13589 Berlin (DE); STÖSSEL, Matthias, 68309 Mannheim (DE); ULLRICH, Raymond, 14621 Schönwalde (DE)
(86) Internationale Anmeldenummer: PCT/DE2005/000381
(87) Internationale Veröffentlichungsnummer: WO 2005/085655

(56) Entgegenhaltungen:
- EP-A- 0 422 746
- DE-A1- 4 446 031
- US-A- 4 690 353
- US-A- 5 774 252
- US-B1- 6 358 021
- US-B1- 6 376 971

## Beschreibung

Die Erfindung bezieht sich auf eine Verkleidung mit einer elastischen, die Oberfläche der Verkleidung bildenden Grenzschicht.

Eine solche Verkleidung lässt sich beispielsweise der EP 422 746 A2 entnehmen. Die Verkleidung besteht aus einem dreischichtigen elastischen Sandwich, wobei die elastischen Schichten durch Stege miteinander verbunden sind. Zwischen den elastischen Schichten sind Elektrodenschichten vorgesehen, die jedoch zumindest mit der zwischen ihnen liegenden Schicht nicht verbunden sind. Werden diese Elektroden mit einer gleichartigen Ladung beaufschlagt, so stoßen diese sich ab. Deshalb entfernt sich die oberflächennahe Elektrodenlage, wobei durch den Aufbau des elastischen Körpers mit Stegen und Schichten dieser hügelförmig verformt wird.

Weiterhin ist aus der US 6,376,971 B1 ein Polymeraktor bekannt. Dieser besteht aus einem elektroaktiven Polymer, welcher durch Elektrodenlagen auf beiden Seiten beschichtet ist. Die Beaufschlagung der Elektrodenlagen mit Ladungen unterschiedlicher Polarität führt zu deren Annäherung, wobei das Material der Polymerlagen nach außen hin verdrängt wird, weswegen eine Oberflächenvergrößerung des Polymeraktors stattfindet.

Eine andere Verkleidung ist durch Ron Pelrin, in "Smart Structures and Materials 2001", Proceedings of SPIE Vol. 4329 (2001) auf den Seiten 335 bis 349 beschreiben. Gemäß dieser Veröffentlichung kann eine Verkleidung aus einem membranartigen Polymeraktor bestehen, welcher auf einem Array von Kreislöchern aufgebracht wird. Oberhalb der Kreislöcher kann sich die Membran durch Anlegen eines elektrischen Feldes an das elektroaktive Polymer verformen, wobei sich der Polymeraktor auf den Stegen zwischen den Kreislöchern abstützt. Hierdurch lässt sich die Oberflächenstruktur der Verkleidung beispielsweise für aerodynamische Zwecke verformen um den Strömungswiderstand zu minimieren.

Als Polymerlage für den Polymeraktor können Elastomere wie z. B. Silikon verwendet werden. Hierdurch lässt sich ein elektrostatischer Elastomeraktor erzeugen, bei dem die Verformung der Polymerlage aufgrund der gegenseitigen Anziehung der Elektrodenlagen bei Vorliegen eines elektrischen Feldes erfolgt. Die Polymerlage kann jedoch auch aus einem elektroaktiven Polymer wie z. B. PMMA (Polymethyl Methacrylate) bestehen. Bei elektroaktiven Polymeren wird die Verformung aufgrund der Anziehung der Elektrodenlagen zusätzlich durch eine aktive Verformung des elektroaktiven Polymers im elektrischen abgesprengt werden muss, um eine Beeinträchtigung der aerodynamischen Eigenschaften der Tragflächen zu verhindern. Zur Verformung der Grenzschicht der Verkleidung wird der Polymeraktor durch Anlegen eines elektrischen Feldes aktiviert, so dass dieser sich verformt. Da die Verkleidung nur in Teilbereichen auf der Unterlage befestigt ist, führt die Verformung zwischen den Teilbereichen im Falle der Ausbildung des Polymeraktors als Membranaktor zu einer Wölbung von der Unterlage weg, so dass zwischen der Unterlage und der Verkleidung in diesen Bereichen ein Hohlraum entsteht. Im verformten Zustand besitzt die Verkleidung aufgrund der ausgebildeten Verwölbung eine erhöhte Eigenstabilität, so dass die fehlende Abstützung durch die Unterlage kompensiert wird. Nach der Enteisung legt sich die Verkleidung wieder fest an die Unterlage an.

Gemäß der Erfindung ist vorgesehen, dass der Polymeraktor als Membranaktor ausgebildet ist. Membranaktoren lassen sich vorteilhaft kostengünstig für große Flächen herstellen. Die Verkleidung kann beispielsweise als folienförmiges Halbzeug hergestellt werden, welches als Verkleidung auf die zu verkleidende Unterlage aufgebracht und dort befestigt wird.

Für die Befestigung ist es vorteilhaft, wenn die Verkleidung in regelmäßigen Abständen punktuell auf der Unterlage befestigt ist. Diese punktuelle Befestigung kann beispielsweise mittels Klebepunkten oder auch durch Nietverbindungen erfolgen, wobei die Nietverbindungen gleichzeitig als elektrische Zuführungen für die zur Aktivierung des Polymeraktors notwendigen Flächenelektroden dienen können.

Es ist weiterhin vorteilhaft, wenn die Verkleidung mit Durchgangslöchern versehen ist. Hierdurch kann sichergestellt werden, dass sich die Verkleidung bei einer Verformung zuverlässig von der Unterlage abheben kann, da durch die Durchgangslöcher ein Druckausgleich zu den sich bildenden Hohlräumen hin möglich ist.

Eine besondere Ausgestaltung der Erfindung wird erhalten, wenn die Verkleidung aus einzeln jeweils mit einem Ende auf der Unterlage befestigten Lamellen zusammengesetzt ist, wobei die Lamellen jeweils als Biegeaktor ausgebildete Polymeraktoren sind. Bei dieser Ausgestaltung der Erfindung ist die Verkleidung nicht durch eine geschlossene Folie gebildet, sondern weist jeweils Schlitze oder Zwischenräume auf, die die einzelnen Lamellen zumindest in Teilbereichen voneinander trennen. Auf diese Weise kann jede Lamelle einzeln als Biegeaktor aufgefasst werden, wobei eine Biegung durch Aktivierung des jeweiligen Polymeraktors erzeugt werden kann. Die Lamellen heben sich aufgrund der Biegung einseitig von der Unterlage ab, da sie mit dem anderen Ende jeweils auf der Unterlage befestigt sind. Die durch die Verkleidung erzeugte Oberfläche ist daher mit Fischschuppen vergleichbar, die gemeinsam die Grenzschicht der Verkleidung bilden und durch Aufstellen der Schuppen verformt werden kann. Der dadurch erreichbare Verformungseffekt ist vorteilhaft besonders groß, so dass die Lamellen besonders gut beispielsweise zum Absprengen einer Eis- oder auch Kalkschicht bei vereisungs- oder verkalkungsgefährdeten Objekten verwendet werden kann. Gleichzeitig lässt sich mittels der Lamellen eine strömungsdynamisch günstige Oberfläche erzeugen, die in der Fachwelt auch als Haifischhaut bezeichnet wird.

Eine weitere Lösung der oben angegebenen Aufgabe sieht vor, dass die Verkleidung mit einer betragsmäßig mit dem Flächeninhalt der Verkleidung übereinstimmenden Anlagenfläche an der verkleideten Unterlage anliegt, wobei die Verkleidung mit der gesamten Anlagefläche fest mit der Unterlage verbunden ist und zumindest eine Elektrodenlage für den Polymeraktor aufweist, die sich nur über einen Teilbereich des Polymeraktors erstreckt. Durch die Verbindung der Verkleidung über die gesamte Anlagefläche wird vorteilhaft eine besonders stabile Verkleidung für die Unterlage geschaffen. Diese Stabilität bleibt auch erhalten, wenn der Polymeraktor verformt wird. Die Verformung des Polymeraktors kommt nämlich nicht durch Abheben der Verkleidung und Auswölben von der Unterlage weg zustande, sondern durch das lediglich lokale Anlegen eines elektrischen Feldes an den Polymeraktor. Ein elektrisches Feld in dem Polymeraktor wird nämlich nur in denjenigen Teilbereichen erzeugt, die sich an die nur Teilbereiche des Polymeraktors abdeckende Elektrodenlage anschließen. Da die anderen Bereiche auch bei Anlegen eines elektrischen Feldes an den Polymeraktor unverformt bleiben, weichen diese Bereiche den angrenzenden verformten Bereichen aus, so dass in den Teilbereichen, in denen sich die Elektrodenlage befindet, eine Verdünnung des Polymeraktors und in den Teilbereichen außerhalb der Elektrodenlage eine Verdickung des Polymeraktors erfolgt. Hierdurch wird die Grenzschicht der Verkleidung verformt, wobei sich eine Topographie mit Erhebungen und Vertiefungen der Grenzschicht einstellt.

Es ist vorteilhaft, wenn die Elektrodenlage die Stege einer wabenartigen Struktur auf der Polymerlage bilden. Hierdurch lässt sich vorteilhaft eine regelmäßige Topografie der verformten Grenzschicht der Verkleidung einstellen, bei der die Erhöhungen nährungweise kreisförmig sind und durch eine wabenförmig zusammenhängende, talartige Vertiefung voneinander getrennt sind. Diese Bauform der Elektrodenlage hat außerdem den Vorteil, dass sie, obwohl sie nur Teilbereiche des Polymeraktors bedeckt eine zusammenhängende Struktur bildet, die einerseits einfach herzustellen und auf die Polymerlage aufzubringen ist und andererseits vorteilhaft auch einfach elektrisch zu kontaktieren ist. Selbstverständlich kann die Elektrodenlage auch anders, z. B. linienförmig strukturiert sein, um z. B. eine Textur der Oberfläche zu erzeugen.

Eine weitere Ausgestaltung der Erfindung besteht darin, dass die Unterlage eine Elektrode für eine Polymerschicht des Polymeraktors bildet. Dies ist nur dann möglich, wenn die Unterlage selbst elektrisch leitend ist. In diesem Fall wird eine Elektrodenlage zwischen der Unterlage und der Polymerlage eingespart, was vorteilhaft den Fertigungsaufwand verringert. Die Unterlage kann beispielsweise geerdet sein, so dass das Potential zur Erzeugung eines elektrischen Feldes an die grenzschichtseitige Elektrodenlage angelegt werden kann.

Zuletzt ist gemäß einer Ausgestaltung beider Varianten der Erfindung vorgesehen, dass die Grenzschicht als Zusatzschicht auf dem Polymeraktor ausgebildet ist. Diese Zusatzschicht kann verschiedene Funktionen übernehmen und vorteilhaft dadurch die Funktionalität der Verkleidung verbessern oder erweitern. Beispielsweise ist eine optische Funktion (Farbstoff, Leuchtschicht) denkbar. Weiter kann die Zusatzschicht eine Schutzfunktion für den Polymeraktor übernehmen, so dass dieser vor Umwelteinflüssen geschützt wird. Auch ist eine Zusatzschicht denkbar, die aufgrund ihrer Oberflächenstruktur einen Lotuseffekt der Oberfläche bewirkt. Wesentlich für die Funktion des Polymeraktors ist jedoch, dass die Zusatzschicht elastisch ist, so dass sie eine Verformung der Grenzschicht nicht verhindert.

Weitere Einzelheiten der Erfindung werden im Folgenden anhand schematischer Ausführungsbeispiele beschrieben. Hierbei zeigen
- Figur 1: ein Ausführungsbeispiel der erfindungsgemäßen Verkleidung, bei der ein membranartiger Polymeraktor mit punktueller Befestigung auf der Unterlage zum Einsatz kommt, im schematischen Schnitt,
- Figur 2: ein Ausführungsbeispiel der erfindungsgemäßen Verkleidung mit lamellenartigen Polymeraktoren als Seitenansicht und
- Figur 3: ein Ausführungsbeispiel der erfindungsgemäßen Verkleidung mit einem ganzflächig fest auf der Unterlage montierten Polymeraktor und einer wabenartigen Elektrode als geschnittene, perspektivische Ansicht.

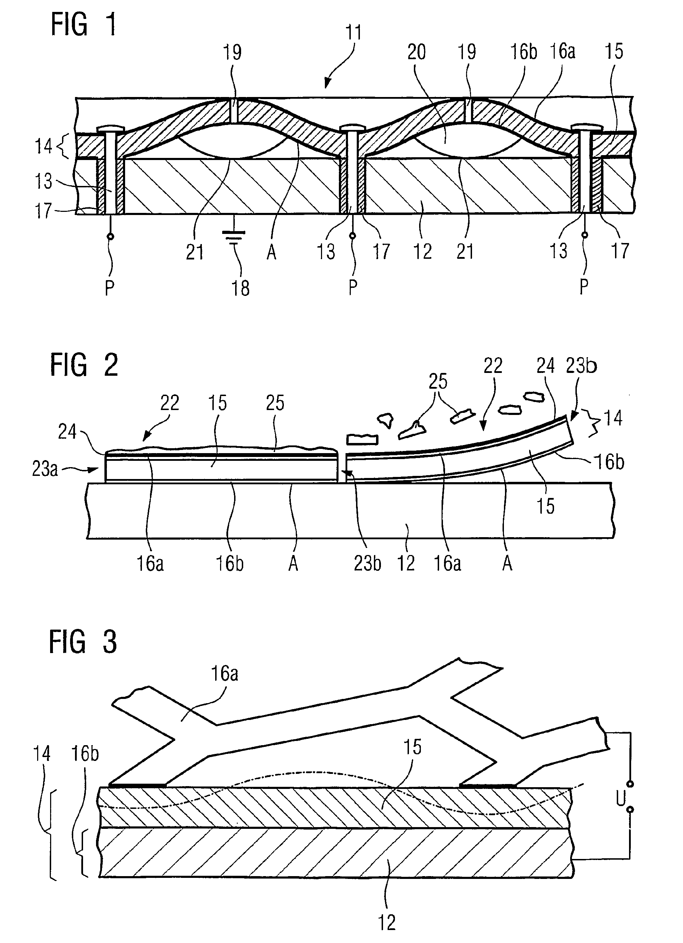

Gemäß Figur 1 ist eine Verkleidung 11 auf einer Unterlage 12, die verkleidet werden soll, mittels Niete 13 punktuell befestigt. Die Verkleidung wird durch einen Polymeraktor 14 gebildet, der als Membranaktor ausgeführt ist. Dieser weist eine Polymerlage 15 aus einem elektroaktiven Polymer auf, welcher beidseitig mit je einer Elektrodenlage 16a, 16b versehen ist. Die Niete 13 sind in elektrisch isolierenden Buchsen 17 in der Unterlage 12 befestigt, so dass eine elektrische Isolation der Niete 13 von der an sich elektrisch leitfähigen Unterlage 12 gewährleistet ist. Die Niete 13 sind elektrisch leitend mit der von der Unterlage abgewandten Elektrodenlage 16a verbunden, während die an die Unterlage 12 angrenzende Elektrodenlage 16b mit dieser kontaktiert ist. die Unterlage 12 kann damit als Erdung 18 der Elektrodenlage 16b zum Einsatz kommen. Wird über die Niete 13 ein Potential P angelegt, so führt das daraus resultierende elektrische Feld in der Polymerlage 15 zum in Figur 1 dargestellten Verformungszustand des Polymeraktors 14, der dadurch gekennzeichnet ist, dass sich zwischen den Niete 13 sich von der Unterlage 12 wegwölbende Bäuche der Verkleidung entstehen.

Mit der Verkleidung gemäß Figur 1 ließen sich beispielsweise die aerodynamischen Eigenschaften einer durch den Polymeraktor 14 gebildeten Grenzschicht verändern. Die Grenzschicht wird im Ausführungsbeispiel gemäß Figur 1 durch die Elektrodenlage 16a gebildet.

Da der Polymeraktor 14 im unverformten Zustand mit einer Anlagefläche A ohne Zwischenraum fest an der Unterlage 12 anliegt (nicht dargestellt), sind in der Verkleidung 11 weiterhin Durchgangslöcher 19 vorgesehen, so dass ein Druckausgleich erfolgen kann, sobald sich aufgrund der Verformung des Polymeraktors 14 ein Hohlraum 20 zwischen der Verkleidung 11 und der Unterlage 12 ausbildet. Im Hohlraum 20 gemäß Figur 1 sind weitere Kontaktstellen 21 der Verkleidung 11 mit der Unterlage 12 dargestellt, die hinter der Schnittebene gemäß Figur 1 liegen und durch verdeckte, den dargestellten Nieten 13 benachbarte Nieten erzeugt werden. Die Niete 13 sind auf der Unterlage jeweils in den Mittelpunkten der Waben eines gedachten Wabenmusters angeordnet.

In den weiteren Figuren sind sich entsprechende Bauelemente mit jeweils den gleichen Bezugszeichen versehen, wobei diese nur insoweit nochmals erläutert werden, wie sich Unterschiede zum Ausführungsbeispiel gemäß Figur 1 ergeben.

Eine Verkleidung gemäß Figur 2 besteht aus Lamellen 22, welche jeweils mit ihrem einen Ende 23a fest mit der Unterlage 12 verbunden sind, während das andere Ende 23b zusammen mit der Anlagefläche A nur auf der Unterlage 12 aufliegt. Die Lamellen 22 weisen Polymeraktoren 14 auf, die als Biegeaktoren ausgeführt sind. Um bei Verformung der Polymerlage 15 eine Biegung der Lamellen 22 hervorzurufen, ist die der Unterlage 12 zugewandte Elektrodenlage 16b mit einer im Vergleich zur Elektrodenlage 16a und einer auf dieser aufgebrachten Zusatzschicht 24 wesentlich höheren Elastizität ausgestattet. Die Biegung der Lamellen wird also dadurch hervorgerufen, dass die Elektrodenlage 16a und die Zusatzschicht 24 einer Dehnung der Polymerlage 15 einen wesentlich größeren Widerstand entgegensetzen als die Elektrodenlage 16b.

Die Zusatzschicht kann je nach ihrer Beschaffenheit zusätzliche Funktionen der Verkleidung erfüllen. Im Ausführungsbeispiel gemäß Figur 2 erhöht sie beispielsweise die Steifigkeit der Elektrodenlage 16a, so dass die Funktionalität des Biegeaktors verbessert wird. Die Zusatzschicht kann beispielsweise aus Teflon bestehen, so dass die Haftung beispielsweise von Kalkablagerungen 25 verringert wird und durch Betätigung der Biegeaktoren ein Absprengen der Kalkablagerungen 25 erleichtert wird.

Die Verkleidung gemäß Figur 3 wird durch die Polymerlage 15 gebildet, die ganzflächig fest mit der Unterlage 12 verbunden ist. Die Unterlage 12 ist elektrisch leitend ausgeführt und bildet insofern gleichzeitig die eine Elektrodenlage 16b zur Aktivierung der Polymerlage 15. Die andere Elektrodenlage 16a besteht aus wabenförmig miteinander verbundenen Stegen auf der freien Oberfläche der Polymerlage 15. Wird an die Elektrodenlagen 16a, 16b eine Spannung U angelegt, so entsteht in der Polymerlage 15 ein elektrisches Feld mit örtlich unterschiedlich starker Ausprägung, wobei das Feld im Bereich der wabenartigen Stege der Elektrodenlage 16a ein Maximum erreicht. Daher ist in diesen Bereichen die Verformung der Polymerlage 15, also die Verringerung ihrer Dicke am stärksten, so dass das Material der Polymerlage in das Wabeninnere der durch die Stege gebildeten Waben verdrängt wird und dort zu einer Verdickung der Polymerlage 15 führt. Hierbei stellt sich das durch die strichpunktierte Linie angedeutete Profil 26 der Oberfläche der Verkleidung ein. Diese Gestaltänderung der Oberfläche kann in der bereits beschriebenen Weise genutzt werden.

Die Polymeraktoren 14 gemäß der Figuren 1 bis 3 weisen jeweils nur eine Polymerlage 15 auf. Allerdings können auch Schichtaktoren mit mehreren Polymerlagen verwendet werden (nicht dargestellt), wobei sich hierdurch die erreichbaren Verformungsbeträge steigern lassen.

## Patentansprüche

1. Verkleidung mit einer elastischen, die Oberfläche der Verkleidung bildenden Grenzschicht und einem in die Verkleidung integrierten Aktor (14) zur Verformung der Grenzschicht, wobei die Verkleidung mit einer betragsmäßig mit dem Flächeninhalt der Verkleidung übereinstimmenden Anlagefläche (A) an der verkleideten Unterlage (12) anliegt,
**dadurch gekennzeichnet,**
**dass** der Aktor als membranartiger Polymeraktor ausgeführt ist, der die Verkleidung bildet, wobei die Anlagefläche nur mit Teilbereichen auf der Unterlage (12) befestigt ist.

2. Verkleidung nach Anspruch 1,
**dadurch gekennzeichnet,**
**dass** diese in regelmäßigen Abständen punktuell auf der Unterlage befestigt ist.

3. Verkleidung nach einem der vorangehenden Ansprüche,
**dadurch gekennzeichnet,**
**dass** die Verkleidung mit Durchgangslöchern (19) versehen ist.

4. Verkleidung nach Anspruch 1,
**dadurch gekennzeichnet,**
**dass** diese aus einzeln jeweils mit einem Ende auf der Unterlage befestigten Lamellen (22) zusammengesetzt ist, wobei die Lammellen jeweils als Biegeaktor ausgebildete Polymeraktoren sind.

5. Verkleidung mit einer elastischen, die Oberfläche der Verkleidung bildenden Grenzschicht und einem in die Verkleidung integrierten Aktor (14) zur Verformung der Grenzschicht, wobei die Verkleidung mit einer betragsmäßig mit dem Flächeninhalt der Verkleidung übereinstimmenden Anlagefläche (A) an der verkleideten Unterlage (12) anliegt,
und wobei die Verkleidung mit der gesamten Anlagefläche (A) fest mit der Unterlage (12) verbunden ist
**dadurch gekennzeichnet,**
**dass** der Aktor als membranartiger Polymeraktor ausgeführt ist, der die Verkleidung bildet und zumindest eine Elektrodenlage (16a) aufweist, die sich nur über einen Teilbereich des Polymeraktors (14) erstreckt.

6. Verkleidung nach Anspruch 5,
**dadurch gekennzeichnet,**
**dass** die Elektrodenlage (16a) die Stege einer wabenartigen Struktur auf der Polymerlage (15) bilden.

7. Verkleidung nach einem der Ansprüche 5 oder 6,
**dadurch gekennzeichnet,**
**dass** die Unterlage (12) eine Elektrode für eine Polymerschicht (15) des Polymeraktors (14) bildet

8. Verkleidung nach einem der vorangehenden Ansprüche,
**dadurch gekennzeichnet,**
**dass** die Grenzschicht als Zusatzschicht (24) auf dem Polymeraktor ausgebildet ist.

## Claims

1. Cladding with an elastic boundary layer which forms the surface of the cladding, and an actuator (14) which is integrated in the cladding for the deformation of the boundary layer,
with the cladding bearing on the cladded substrate (12) by means of a bearing area (A) which matches the surface area of the cladding in terms of magnitude, **characterized in that** the actuator is designed as a membrane-like polymer actuator which forms the cladding, with only subregions of the bearing area being fixed to the substrate (12).

2. Cladding according to Claim 1,
**characterized**
**in that** this cladding is fixed to the substrate at regular intervals in a punctiform manner.

3. Cladding according to one of the preceding claims,
**characterized**
**in that** the cladding is provided with through-holes (19).

4. Cladding according to Claim 1,
**characterized**
**in that** this cladding is composed of individual lamellae (22) which are each fixed to the substrate by means of one end, with the lamellae each being polymer actuators in the form of bending actuators.

5. Cladding comprising an elastic boundary layer which forms the surface of the cladding, and an actuator (14) which is integrated in the cladding for the deformation of the boundary layer,
with the cladding bearing against the cladded substrate (12) by means of a bearing area (A) which matches the surface area of the cladding in terms of magnitude, and with the cladding being firmly connected to the substrate (12) by means of the entire bearing area (A), **characterized in that** the actuator is designed as a membrane-like polymer actuator which forms the cladding and has at least one electrode layer (16a) which extends only over a subregion of the polymer actuator (14).

6. Cladding according to Claim 5,
**characterized**
**in that** the electrode layer (16a) forms the webs of a honeycomb-like structure on the polymer layer (15).

7. Cladding according to either of Claims 5 or 6,
**characterized**
**in that** the substrate (12) forms an electrode for a polymer layer (15) of the polymer actuator (14).

8. Cladding according to one of the preceding claims,
**characterized**
**in that** the boundary layer is in the form of an auxiliary layer (24) on the polymer actuator.

## Revendications

1. Revêtement ayant une couche limite élastique formant la surface du revêtement et un actionneur (14) intégré au revêtement pour déformer la couche limite, le revêtement étant appliqué à un support (12) revêtu par une surface (A) de contact coïncidant en valeur absolue avec la superficie du revêtement,
**caractérisé**
**en ce que** l'actionneur est réalisé sous la forme d'un actionneur polymère du type à membrane, qui forme le revêtement, la surface de contact n'étant fixée au support (12) que par des zones partielles.

2. Revêtement suivant la revendication 1,
**caractérisé**
**en ce qu'**il est fixé à des intervalles réguliers ponctuellement au support.

3. Revêtement suivant l'une des revendications précédentes,
**caractérisé**
**en ce que** le revêtement est muni de trous (19) traversants.

4. Revêtement suivant la revendication 1,
**caractérisé**
**en ce qu'**il est composé de lamelles (22) individuelles fixées respectivement par une extrémité au support, les lamelles étant respectivement des actionneurs polymères constitués sous la forme d'actionneurs en flexion.

5. Revêtement ayant une couche limite élastique formant la surface du revêtement et un actionneur (14) intégré au revêtement pour déformer la couche limite, le revêtement étant appliqué à un support (12) revêtu par une surface (A) de contact coïncidant en valeur absolue avec la superficie du revêtement,
et dans lequel le revêtement est relié solidement par toute la surface (A) d'appui au support (12),
**caractérisé**
**en ce que** l'actionneur est réalisé sous la forme d'un actionneur polymère du type à membrane, qui forme le revêtement et a au moins une couche (16a) d'électrode qui ne s'étend que sur une zone partielle de l'actionneur (14) polymère.

6. Revêtement suivant la revendication 5,
**caractérisé**
**en ce que** les couches (16a) d'électrode forment les parties pleines d'une structure à nids d'abeille sur la couche (15) de polymère.

7. Revêtement suivant l'une des revendications 5 ou 6,
**caractérisé**
**en ce que** le support (12) forme une électrode pour une couche (15) de polymère de l'actionneur (14) polymère.

8. Revêtement suivant l'une des revendications précédentes,
**caractérisé**
**en ce que** la couche limite est constituée sous la forme d'une couche (24) supplémentaire sur l'actionneur polymère.
